(19) Europäisches Patentamt

European Patent Office

Office européen des brevets

(11) EP 1 729 323 A1

(12) DEMANDE DE BREVET EUROPEEN

(43) Date de publication:
06.12.2006 Bulletin 2006/49

(51) Int Cl.:
*H01J 37/32* (2006.01)   *G01N 21/71* (2006.01)

(21) Numéro de dépôt: 06370018.1

(22) Date de dépôt: 30.05.2006

(84) Etats contractants désignés:
AT BE BG CH CY CZ DE DK EE ES FI FR GB GR HU IE IS IT LI LT LU LV MC NL PL PT RO SE SI SK TR
Etats d'extension désignés:
AL BA HR MK YU

(30) Priorité: 31.05.2005 FR 0505495

(71) Demandeurs:
• Université des Sciences et
59655 Villeneuve D'Ascq (FR)
• Institute For Terotechnology
26600 Radom (PL)

(72) Inventeurs:
• Grushin, Mihail
142190 Troitsk
Moscow Region (RU)

• Supiot, Philippe
59000 Lille (FR)
• Walkowicz, Jan
26 600 Radom (PL)
• Smolik, Jerzy
26 600 Radom (PL)
• Brudnias, Rafal
26 600 Radom (PL)
• Przybylski, Jan
26 600 Radom (PL)

(74) Mandataire: Hennion, Jean-Claude et al
Cabinet Beau de Loménie
27 bis, rue du Vieux Faubourg
F-59800 Lille (FR)

(54) **Procédé de contrôle d'un processus de nitruration assistée par plasma et système mettant en oeuvre ledit procédé**

(57) La présente invention a pour objet un procédé de contrôle d'un processus de nitruration assistée par plasma comme première étape d'un traitement duplex continu appliqué à des outils de forge à chaud. Le procédé de contrôle d'un processus de nitruration assistée par plasma, d'un substrat en acier placé dans une enceinte, comprend une étape d'introduction dans ladite enceinte d'un mélange gazeux A comprenant de l'azote, et une étape de formation dans ladite enceinte d'un plasma de décharge comprenant des espèces réactives vis à vis de la nitruration dudit substrat en acier. Ledit procédé comprend en outre les étapes suivantes :

a. mesurer par spectroscopie optique d'émission (SOE) les émissions optiques provenant de deux espèces réactives E1 et E2 présentes dans le plasma de décharge dans le voisinage du substrat, pour obtenir des valeurs $D1_i$ et $D2_i$ correspondant aux signaux analogiques liés aux émissions des espèces E1 et E2 respectivement;

b. traiter les données $D1_i$ et $D2_i$ en vu d'obtenir un paramètre $X_i$ et de comparer celui-ci à une valeur de référence $X_r$;

c. ajuster, le cas échéant, le débit d'au moins un des constituants gazeux et/ou la pression du mélange A afin de maintenir le paramètre X proche de la valeur $X_r$ pendant toute la durée de la nitruration.

FIG.1

**Description**

La présente invention a pour objet un procédé de contrôle d'un processus de nitruration assistée par plasma comme première étape d'un traitement duplex continu appliqué à des outils de forges à chaud.

L'amélioration des propriétés mécaniques et tribologiques de l'acier par la diffusion assistée par traitement thermochimique est maintenant bien répandue dans l'industrie de la fabrication mécanique. Les procédés de nitruration assistée par plasma ont montré leurs potentiels pour accomplir de tels traitements qui conduisent souvent à une meilleure qualité des couches nitrurées. Le taux et le degré de nitruration dans les procédés mentionnés ci-dessus dépendent de beaucoup de variables incluant, entre autres, la température, la puissance transmise à la décharge, les débits gazeux et la pression dans l'enceinte de traitement.

Par ailleurs, indépendamment du type de procédé de nitruration utilisé, il est impossible de déterminer en ligne la profondeur, la structure et la composition des phases présentes dans la couche nitrurée. De plus, aucun potentiel de nitruration comme celui propre aux réacteurs de diffusion thermiques classiques ne peut être défini dans un procédé assisté par plasma du fait de l'existence d'une forte déviation à l'équilibre thermodynamique. Il est alors difficile de déceler et de contrôler de façon univoque les réactions élémentaires prenant naissance dans le plasma et qui sont responsables des dérives dans les conditions de nitruration.

La composition et la structure des phases des couches nitrurées sont d'une importance critique dans le traitement duplex de surface consistant en une phase de nitruration du substrat et une phase de dépôt subséquente d'un revêtement par PVD. Ces paramètres déterminent en effet la cohésion des éléments composites couche nitrurée (Fe ($\alpha$)N)/revêtement PVD créés. Lorsque les propriétés de dureté et de résistance mécanique et thermiques sont seules recherchées, la nature et la composition (richesse en phases $Fe_4N$ et $Fe_{2-3}N$) doivent également être maîtrisées. Par conséquent, les systèmes automatiques pour contrôler le procédé de nitruration sont nécessaires, spécialement lorsque les traitements duplex sont exécutés en régime continu.

Différents types de méthodes de contrôle du procédé de nitruration par plasma des aciers ont été décrites dans la littérature, dans lesquelles le chauffage des pièces nitrurées et le contrôle de leur température se font exclusivement par l'ajustement des caractéristiques de décharges lumineuses. Le document FR 2.698.377 divulgue un procédé de pilotage d'une installation de nitruration ionique basé sur la mesure spectroscopique de l'excitation vibrationnelle de l'ion azote $N_2^+$. Ce signal spectroscopique est traité numériquement afin de déterminer l'amplitude de l'excitation vibrationnelle de l'ion azote. Les données ainsi obtenues permettent de réguler la forme du signal électrique pulsé délivré par le générateur de courant. Dans une première phase de l'optimisation du procédé de nitruration, le rapport cyclique du courant électrique est maintenu constant et la densité du courant appliqué est augmentée jusqu'à obtenir une excitation vibrationnelle maximale de l'ion azote et un plasma stable. Dans une deuxième phase, la température de la cathode est régulée en faisant varier le rapport cyclique de la décharge, la densité du courant ayant conduit au maximum d'excitation vibrationnelle étant maintenue constante.

La présente invention se propose de montrer qu'il est possible de stabiliser l'intensité de nitruration à un niveau requis, garantissant l'obtention de la composition recherchée de la couche nitrurée, malgré les fluctuations des caractéristiques de la décharge luminescente. Le procédé conforme à la présente invention s'appuie sur des mesures in situ des émissions optiques pendant le procédé de nitruration assistée par plasma et utilise les émissions mesurées pour le contrôle de l'intensité de la nitruration.

A cet effet et selon un premier aspect, l'invention a pour objet un procédé de contrôle d'un processus de nitruration assistée par plasma, d'un substrat en acier placé dans une enceinte, ledit procédé comprenant une étape d'introduction dans ladite enceinte d'un mélange gazeux A comprenant de l'azote, et une étape de formation dans ladite enceinte d'un plasma de décharge comprenant des espèces réactives vis à vis de la nitruration dudit substrat en acier, ledit procédé étant caractérisé en ce qu'il comprend en outre les étapes suivantes :

   a. mesurer par spectroscopie optique d'émission (SOE) les émissions optiques provenant de deux espèces réactives et émettrices E1 et E2 présentes dans le plasma de décharge dans le voisinage du substrat, pour obtenir des valeurs $D1_i$ et $D2_i$ correspondant aux signaux analogiques liés aux émissions des espèces E1 et E2 respectivement;
   b. traiter les données $D1_i$ et $D2_i$ en vu d'obtenir un paramètre $X_i$ et de comparer celui-ci à une valeur de référence $X_r$;
   c. ajuster, le cas échéant, le débit d'au moins un des constituants gazeux et/ou la pression du mélange A afin de maintenir le paramètre X proche de la valeur $X_r$ pendant toute la durée de la nitruration.

Les espèces réactives E1 et E2 sont sélectionnées dans le groupe : $N_2^+$ (FNS), $N_2$ (SPS) et H (n=3,4,5,6). De manière préférée, les espèces E1 et E2 sont $N_2^+$ et H (n=3).

Dans un mode de réalisation préféré, le paramètre $X_i$ est défini par le rapport des données $D1_i$ et $D2_i$ ($X_i = D1_i/D2_i$). Dans un autre mode de réalisation, le paramètre $X_i$ est défini par le rapport des données $D2_i$ et $D1_i$ ($X_i = D2_i/D1_i$).

Selon un deuxième aspect, l'invention concerne un système pour la mise en oeuvre du procédé de contrôle précité, ledit système comprenant :

- une enceinte réactionnelle comportant un support cathodique et des moyens d'obtention d'un plasma de décharge à partir d'un mélange gazeux A comprenant de l'azote introduit dans ladite enceinte; l'enceinte présentant une fenêtre permettant le passage du rayonnement émis par le plasma ;
- des moyens de transmission optique aptes à diriger le rayonnement émis pas le plasma à travers ladite fenêtre vers des moyens collecteurs de rayonnement;
- une unité centrale recevant les données transmises par lesdits moyens collecteurs de rayonnement;
- des moyens de contrôle et de transmission d'une commande émanant de l'unité centrale vers un dispositif de contrôle et régulation des paramètres du mélange gazeux A.

L'invention et les avantages qu'elle procure seront mieux compris à la lumière de la description détaillée qui va suivre faite en référence aux dessins annexés donnés à titre d'exemples non limitatifs de l'invention.

La figure 1 représente de manière schématique un système pour la mise en oeuvre du procédé de contrôle de la nitruration assistée par plasma selon une variante de réalisation de la présente invention.

La figure 2 montre les spectres d'émissions optiques provenant du plasma de nitruration dans le domaine spectral 300-700 nm.

La figure 3 montre l'évolution temporelle typique de la caractéristique U-I de la décharge luminescente durant le procédé de nitruration assistée par plasma.

La figure 4 montre les changements de la période d'oscillation des paramètres de décharge (courant, tension, intensités d'émissions mesurées dans le voisinage du substrat situé dans l'enceinte réactionnelle) en fonction du pourcentage d'azote, pour deux conditions de préchauffage.

La figure 5a montre les chronogrammes des intensités des émissions principales mesurées dans le voisinage du substrat situé dans l'enceinte réactionnelle pendant le procédé de nitruration, pour différents pourcentages d'azote.

La figure 5b montre les intensités d'émissions $N_2^+(B^2\Sigma_u^+, v'=0 \to X^2\Sigma_g^+, v''=0)$ (FNS ; 391,4 nm), $N_2(C^3\Pi_u, v'=0 \to B^3\Pi_g, v''=0)$ (SPS ; 380,4 nm) et $H_\alpha(n'=2 \to n=3$ ; 656,2 nm) enregistrées pendant le procédé de nitruration, pour différents pourcentages d'azote, dans le voisinage du substrat situé dans l'enceinte réactionnelle et deux conditions de préchauffage.

La figure 6 montre un détail du système de la figure 1 présentant un schéma du dispositif de contrôle des paramètres du mélange gazeux A.

La figure 7 représente l'évolution temporelle des émissions FNS, $H_\alpha$ et le rapport FNS/ $H_\alpha$ pour différents pourcentages d'azote (p=300 Pa).

La figure 8 montre l'évolution de la valeur moyenne du rapport FNS/ $H_\alpha$ en fonction du pourcentage d'azote dans les conditions de la figure 7.

La figure 9 représente la variation de la valeur moyenne du rapport FNS/SPS en fonction du pourcentage d'azote, obtenue à partir des émissions enregistrées à l'aide d'un spectrographe dans les mêmes conditions que celle de la figure 7.

La figure 10a représente la variation dans le temps des valeurs du FNS, $H_\alpha$ et du rapport FNS/$H_\alpha$ enregistrées pendant la nitruration assistée par plasma de substrats de grande taille sans utiliser la présente invention.

La figure 10b représente la variation dans le temps des valeurs du FNS, $H_\alpha$ et du rapport FNS/ $H_\alpha$ enregistrées pendant la nitruration assistée par plasma de substrats de grande taille en impliquant la présente invention.

La figure 11 montre un organigramme illustrant le procédé de contrôle du processus de nitruration assistée par plasma selon l'invention.

La figure 12 représente un chronogramme des valeurs du FNS, $H_\alpha$ et du rapport FNS/$H_\alpha$ enregistrées pendant la nitruration assistée par plasma de substrats en utilisant la présente invention sur un réacteur de type Standard 1.

La présente invention se rapporte à un procédé de contrôle d'un processus de nitruration assistée par plasma, d'un substrat en acier placé sur un support cathodique dans une enceinte dans laquelle est introduit un mélange gazeux A comprenant de l'azote, dans des conditions permettant de former dans ladite enceinte un plasma de décharge conduisant à la nitruration dudit échantillon en acier.

La méthode associée à la présente invention peut être utilisée in situ dans toute enceinte de procédé plasma dans laquelle un spectromètre ou autre type de collecteur de rayonnement peut être adapté sur le réacteur. La mesure est ainsi réalisée sur le réacteur qui inclue une fenêtre ou un orifice au travers duquel le rayonnement émis par le plasma peut être redirigé par un système de transmission optique vers un spectromètre situé en dehors de l'enceinte.

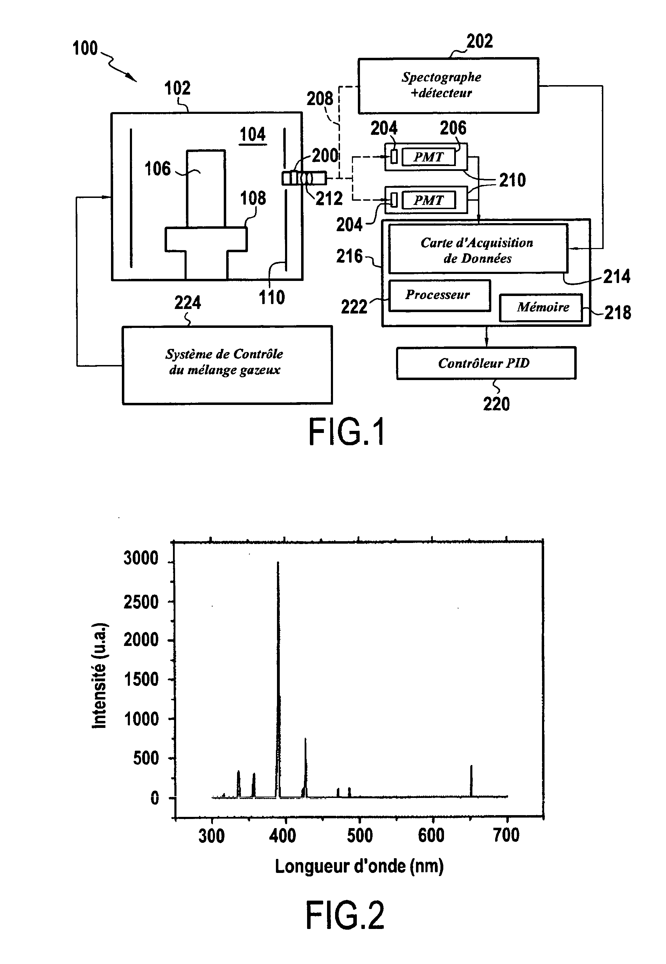

La Figure 1 montre un système 100 configuré pour la mise en oeuvre du procédé de contrôle de la nitruration assistée par plasma. Comme montré par cette figure, le système 100 inclut une enceinte réactionnelle 102 qui entoure une zone de traitement 104 d'un substrat 106 porté par un support cathodique 108. Dans l'enceinte réactionnelle 102 est introduit un mélange gazeux A comprenant de l'azote. La composition du mélange gazeux A ainsi que sa pression sont contrôlées au moyen d'un dispositif de contrôle et régulation 224 des paramètres du mélange gazeux A.

Durant le procédé de nitruration, le support cathodique 108 est polarisé par application d'une puissance électrique (dispositif non représenté) conduisant à la formation d'un plasma dans la région 104. Le substrat 106 est chauffé par le plasma environnant et un écran métallique 110 est utilisé pour limiter les pertes de chaleur. Le plasma génère des rayonnements électromagnétiques qui incluent des émissions ayant des longueurs d'onde dans le domaine optique (i.e. dans le domaine allant de 200 à 1000 nm). Une fraction de ces émissions venant du voisinage du substrat 106 (zone particulièrement lumineuse, d'environ 5 mm d'épaisseur, située à la lisière de la gaine électrostatique assurant la majorité de la différence de potentiel accélérateur des ions positifs depuis le plasma de la région 104 et vers le substrat 106) peut être détectée au travers d'une fenêtre 200 par l'intermédiaire de moyens collecteurs de rayonnement, représentés soit par un spectrographe 202 équipé d'un ou plusieurs détecteurs, soit par un jeu de deux filtres spectraux 204 équipés chacun d'un photomultiplicateur (PMT) 206. Les filtres 204 et les photomultiplicateurs 206 constituent un dispositif Filtres-PMT (F-PMT) 210. Le rayonnement passant au travers de la fenêtre optique 200 est transmis, soit au spectrographe 202 soit au système F-PMT 210, par l'intermédiaire de moyens de transmission optique comprenant un câble à fibre optique 208 (multiplexé ou non) et un jeu de lentilles 212 qui collimate le rayonnement passant au travers de la fenêtre 200 dans le câble optique 208.

Les radiations provenant du voisinage du substrat 106 et passées à travers la fenêtre 200 sont séparées en fonction de leurs longueurs d'onde soit par le spectrographe 202 soit par le dispositif F-PMT 210. Des signaux de détection, proportionnels aux intensités liées aux longueurs d'onde séparées spatialement, sont ainsi générés et transmis vers une unité centrale 216. Celle-ci, comprenant notamment une carte d'acquisition de données 214, unité de stockage 218 et un processeur 222 collecte avec une vitesse d'échantillonnage périodique les données associées aux longueurs d'onde séparées. Par ailleurs, l'unité centrale 216 commande également le fonctionnement du réacteur 102 à l'aide de différentes lignes de contrôle (non représentées) en exécutant les instructions stockées dans l'unité de stockage 218. En particulier, l'unité centrale 216 commande des moyens de contrôle et de transmission 220, représentés, dans une variante de réalisation, par un contrôleur PID (Process Identifier Device) qui coordonne le dispositif de contrôle et régulation 224 du mélange gazeux A. Le dispositif de contrôle et régulation 224 modifie la pression du mélange gazeux A et le rapport des débits de ses composés en fonction des instructions données par le contrôleur PID 220.

Le procédé de contrôle d'un processus de nitruration assistée par plasma selon l'invention comprend les étapes suivantes :

a. mesurer par spectroscopie optique d'émission (SOE) les émissions optiques provenant de deux espèces réactives et émettrices E1 et E2 présentes dans le plasma de décharge dans le voisinage du substrat 106, pour obtenir des valeurs $D1_i$ et $D2_i$ correspondant aux signaux analogiques liés aux émissions des espèces E1 et E2 respectivement;

b. traiter les données $D1_i$ et $D2_i$ en vu d'obtenir un paramètre $X_i$ et de comparer celui-ci à une valeur de référence $X_r$ mesurée antérieurement et stockée dans une base de données ;

c. ajuster, le cas échéant, le débit d'au moins un des constituants gazeux et/ou la pression du mélange A afin de maintenir le paramètre X proche de la valeur $X_r$ pendant toute la durée de la nitruration.

Les mesures durant le procédé de nitruration montrent les contributions spectrales de chaque longueur d'onde individuelle comme il est visible sur la Figure 2 dans des conditions typiques dans le domaine spectral 300-700 nm. Ce spectre d'émission a été obtenu à l'aide d'un spectrographe 202 équipé d'un détecteur CCD.

Les émissions observées pouvant être utilisées pour le suivi du procédé sont les suivantes:

- $N_2^+$ ($B^2\Sigma_u^+$, v'$\rightarrow$$X^2\Sigma_g^+$, v") (FNS : transition FNS),
- $N_2$ ($C^3\Pi_u$, v'$\rightarrow$$B^3\Pi_g$, v") (SPS) et
- H (n'=1,2,3$\rightarrow$n=2,3, 4, 5, 6,7,8) (transitions optiques permises)

Les espèces émettrices et réactives E1 et E2 sont sélectionnées dans le groupe responsable des émissions: $N_2^+$ ($B^2\Sigma_u^+$, v'=0$\rightarrow$$X^2\Sigma_g^+$, v"=0) (FNS ; 391,4 nm), $N_2$ ($C^3\Pi_u$, v'=0$\rightarrow$$B^3\Pi_g$, v"=0) (SPS ; 380,4 nm) et $H_\alpha$ (n'=2$\rightarrow$n=3 ; 656,2 nm). Dans le cas de mélanges A riches en hydrogène, de manière préférée, les espèces émettrices et réactives E1 et E2 sont $N_2^+$ et H, au travers des émissions FNS ($N_2^+$) et $H_\alpha$ respectivement. Le lien entre espèces émettrices et espèces réactives peut être fait au travers du fait que les émissions FNS et H sont représentatives de l'état énergétique du plasma et des concentrations relatives, respectivement, en ions $N_2^+$, qui contribuent au même titre au bombardement ionique du substrat 106 et en atomes H jouant un rôle réducteur dans la décomposition des phases oxydées du fer (phases $Fe_3O_4$, $Fe_4N$, $Fe_{2-3}N$) durant le procédé et permettent un contrôle idéal de la qualité de la couche de diffusion (Fe($\alpha$) N) lorsqu'elle est souhaitée. Lorsque cette phase Fe($\alpha$)N n'est pas souhaitée, car moins dure que les phases $Fe_4N$ et $Fe_{2-3}N$, un mélange gazeux A riche en azote est considéré et les espèces $E_1$ et $E_2$ peuvent alors être, de manière préférée, $N_2^+$ et H.

Des expériences réalisées par les demandeurs indiquent que les données de SOE fournies par les émissions optiques du plasma varient dans le temps durant le procédé de nitruration exécuté dans l'enceinte 102. Ces fluctuations sont dues à celles touchant la tension électrique (U) et le courant (I) qui elles-mêmes résultent du chauffage par effet Joule du substrat 102 (en contact avec le support cathodique 108) dans la décharge. Ce chauffage est contrôlé par le courant de décharge.

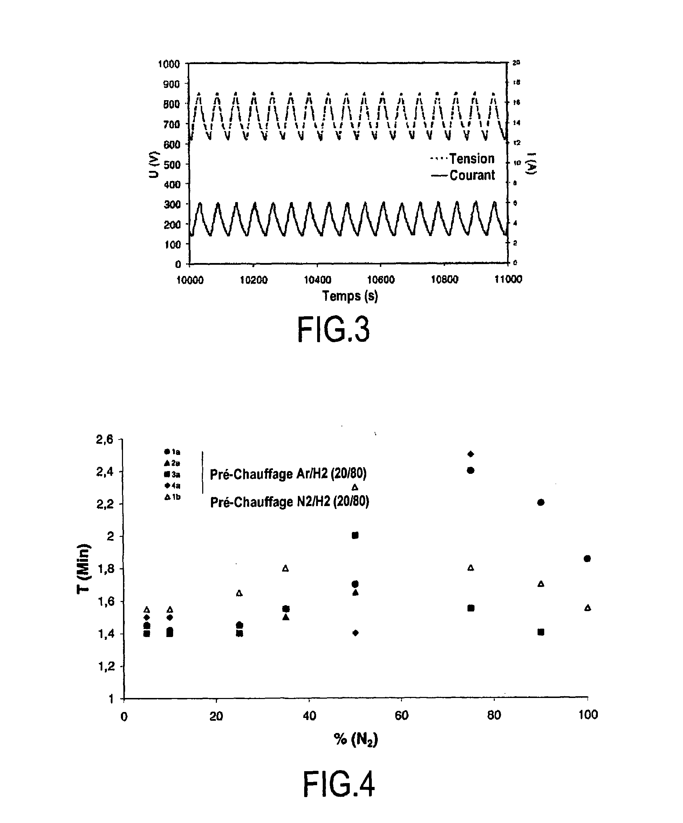

La Figure 3 montre des oscillations typiques de la tension et du courant enregistrées durant le procédé de nitruration. En supposant que les paramètres du procédé tels que la puissance dissipée dans la décharge, la température du substrat 106, les débits gazeux ainsi que la pression, restent constants, pour un procédé et un substrat 106 fixés, les données SOE moyennes provenant des émissions du plasma ne devraient pas varier au cours du temps. Cependant, les demandeurs ont relevé que les changements de la taille du substrat 106 et du matériau affectent sérieusement les conditions de chauffages, et par conséquent, le déroulement du procédé de nitruration par plasma dans son ensemble (Figure 4). Ces observations suggèrent la nécessité d'un contrôle automatisé des procédés de nitruration plasma s'appuyant sur le suivi des caractéristiques du plasma.

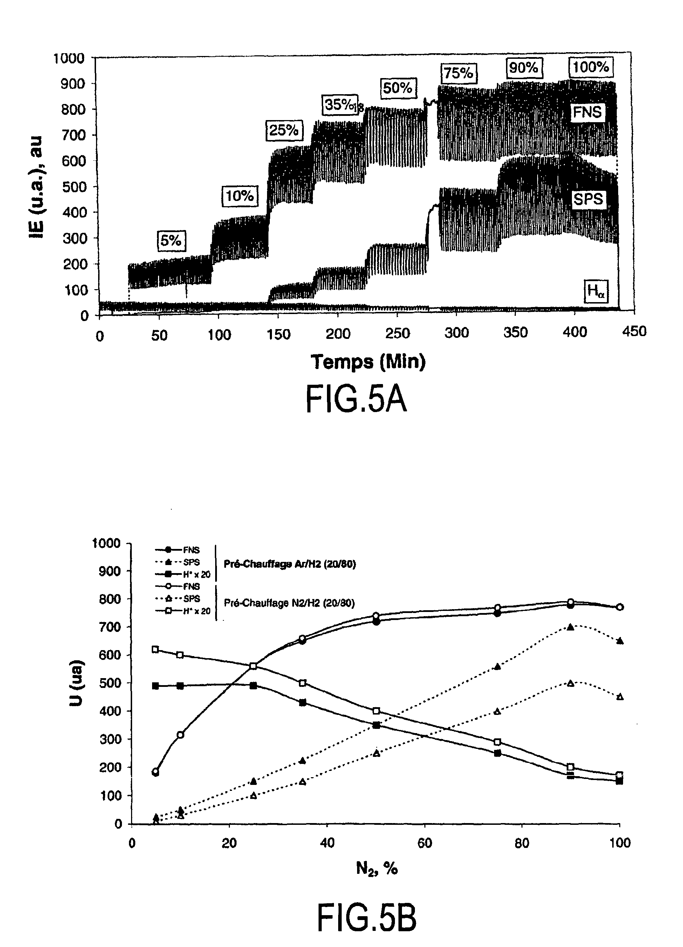

La Figure 5a montre les chronogrammes des intensités des émissions $N_2^+$ ($B^2\Sigma_u^+$, v'=0→$X^2\Sigma_g^+$, v"=0) (FNS ; 391,4 nm), $N_2$ ($C^3\Pi_u$, v'=0→$B^3\Pi_g$, v"=0) (SPS ; 380,4 nm) et $H_\alpha$ (n'=2→n=3 ; 656,2 nm) au cours du procédé de nitruration pour plusieurs pourcentages d'azote dans le mélange. Ces signaux enregistrés illustrent l'existence d'oscillations de grandes amplitudes des intensités d'émission quel que soit l'émetteur. Les demandeurs ont montré qu'il s'agit d'une conséquence directe des oscillations de la puissance dissipée dans le plasma qui sont imposées par le système de contrôle de température du substrat 106 nitruré tel que conçu dans la présente invention. Le système de contrôle de la température (non représenté) du substrat 106 introduit une régulation du courant électrique afin de satisfaire la consigne de température. Les fluctuations des émissions optiques sont la conséquence de celles, au niveau local, des champs et courants électriques.

La Figure 5b montre les intensités moyennes des émissions $N_2^+$ ($B^2\Sigma u^+$, v'=0→$X^2\Sigma g^+$, v"=0) (FNS ; 391,4 nm), $N_2$ ($C^3\Pi_u$, v'=0→$B^3\Pi_g$, v"=0) (SPS ; 380,4 nm) et $H_\alpha$ (n'=2→n=3 ; 656,2 nm) obtenues à l'aide du spectrographe 202 durant le procédé de nitruration pour différents pourcentage d'azote et deux conditions de pré-chauffage : Ar/$H_2$ (20/80) et $N_2$/$H_2$ (20/80). La Figure 5b complète les données de la Figure 4 et montre l'écart des propriétés d'émission du milieu lorsque les conditions de préchauffage du substrat 106 et les compositions du mélange gazeux A changent. Cet exemple spécifique illustre l'influence des conditions initiales sur les caractéristiques des émissions optiques déterminées par la chimie et les paramètres (densités et énergies des électrons et des ions) du plasma. L'exemple de la Figure 5b montre de forts changements dans les valeurs moyennes des intensités des émissions de FNS, SPS et $H_\alpha$ en fonction des conditions. Les demandeurs ont montré, sur la base des intensités d'émission, que des signaux stables proportionnels à l'intensité de la nitruration pouvaient être extraits de façon exploitable pour un contrôle de procédé automatique.

Les essais ont été réalisés dans des réacteurs de traitement duplex en continu développés sur la base d'un appareil de PVD par arc sous vide MZ-383 (fabriqué par Métaplas Ionon, Cologne (Allemagne)) équipé de générateurs de puissance à courant continu pulsé produisant un plasma de décharge dans le mélange $N_2$/$H_2$.

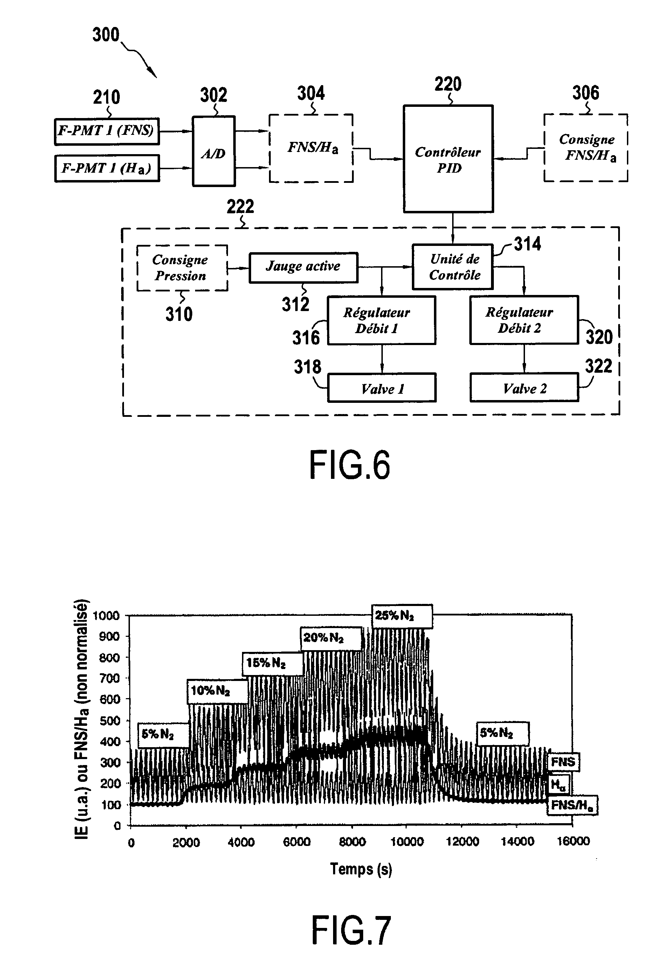

La Figure 6 montre un détail du système 100, présentant un schéma du dispositif de contrôle 224 des paramètres du mélange gazeux A. Des signaux analogiques transmis par le dispositif F-PMT 210, notés F-PMT 1 et F-PMT 2, liés respectivement aux émissions FNS et $H_\alpha$ observées à un moment donné $T_i$ et désignés dans le cadre de la présente invention par $D1_i$ et $D2_i$, sont numérisés par un convertisseur A/D 302. Le rapport calculé 304 désigné ici par une variable X ($X_i = D1_i/D2_i$) est dirigé à l'entrée du contrôleur PID 220 et comparé à une valeur de référence $X_r$ déterminée précédemment en fonction de la structure et la composition de phase de la couche nitrurée. Dans une variante de réalisation la comparaison entre une valeur du paramètre $X_i$ et celle du paramètre de référence $X_r$ se fait par une technique de reconnaissance des formes.

L'analyse comparée effectuée par le contrôleur PID 220 conduit à des instructions adressées au système de contrôle du mélange gazeux A 224 au travers une unité de contrôle 314. Une unité de consigne de la pression 310 fixe la pression mesurée par ailleurs par une jauge active 312, tout d'abord par le contrôle d'un premier régulateur de débit massique 316 qui pilote une première valve 318, puis par l'envoi d'instructions à l'unité de contrôle 314. Le débit massique total est ajusté selon les instructions envoyées en parallèle par le contrôleur PID 220 et la jauge active 312 afin de maintenir la pression et la variable X, proportionnelle au rapport FNS/$H_\alpha$, constants. Les deux contraintes sont satisfaites par l'ajustement d'une seconde valve 322 pilotée par un second régulateur de débit massique 320.

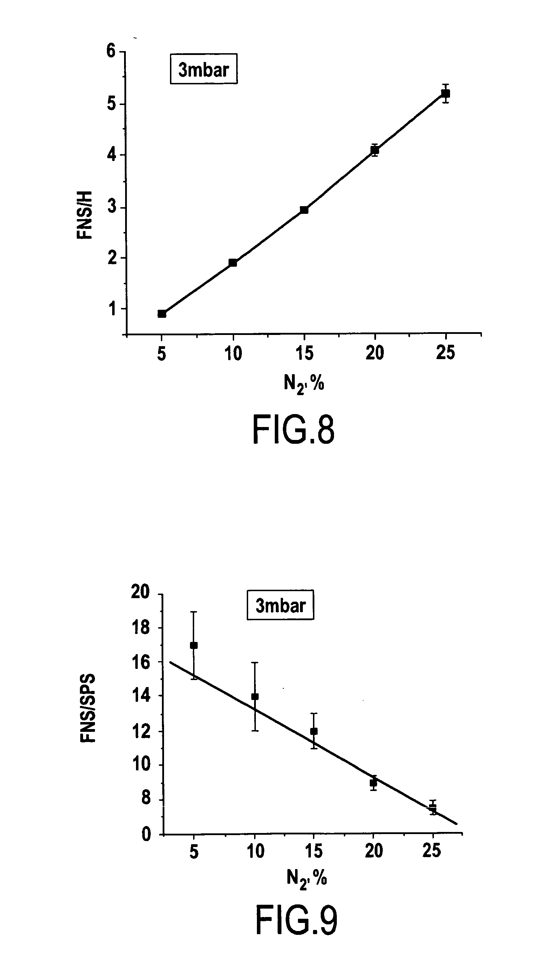

La Figure 7 montre le signal résultant de l'enregistrement simultané des émissions FNS et $H_\alpha$ effectué à l'aide de l'ensemble F-PMT 210 ainsi que le rapport FNS/$H_\alpha$ 304 obtenu en ligne selon le procédé de contrôle décrit dans la présente invention. Les résultats sont montrés pour des séquences de faibles durées pour différentes valeurs du pourcentage de $N_2$ allant jusqu'à 25%. Ces conditions sont intéressantes pour l'obtention des couches nitrurées de haute qualité ne présentant qu'une couche de diffusion dans le cadre d'un traitement duplex continu. Les demandeurs ont montré qu'il était possible de générer un paramètre sans dimension FNS/$H_\alpha$ stable avec une incertitude de 5% quelles que soient les conditions utilisées dans le cadre de la définition de la présente invention comme l'indique la Figure 8. En particulier pour les faibles valeurs du pourcentage de $N_2$, utilisées en traitement duplex en continu, le rapport FNS/$H_\alpha$ (matérialisé dans le paramètre X), est un paramètre de contrôle pour le suivi et le contrôle des procédés de nitruration plasma. Cette observation contraste avec les résultats obtenus lors du suivi du rapport FNS/SPS durant des périodes de fonctionnement de courtes durées. Ce résultat est illustré par la Figure 9 qui montre la dépendance de la valeur moyenne de ce dernier par rapport au pourcentage d'azote. Les valeurs de ce rapport souffrent d'une forte dispersion et excluent la possibilité d'utiliser le rapport FNS/SPS dans le cadre du procédé de contrôle selon la présente invention.

Les résultats obtenus montrent que le paramètre de contrôle choisi, FNS/$H_\alpha$ n'est influencé ni par la taille, la forme du substrat 106 et le(s) matériau(x) qui le constitue(nt), ni par les dimensions de l'enceinte réactionnelle 102. La conception des moyens de transmission optique (jeu de lentilles 212 et câble optique 208) est telle que le volume de plasma sondé est le même pour les signaux d'émission (FNS et $H_\alpha$). La proportionnalité avec le volume émetteur V et la concentration de l'espèce émettrice ([Emetteur]) de cette intensité émise IE associée à une longueur d'onde $\lambda$ est montrée par la relation suivante :

$$IE(\lambda)= K(\lambda) \cdot V \cdot [Emetteur]$$

$K(\lambda)$ est un facteur de proportionnalité dépendant de $\lambda$. Ainsi l'influence du substrat 106 est gommée au travers de la définition suivante du rapport FNS/$H_\alpha$ du fait que V1 et V2 sont les mêmes:

$$FNS/H_\alpha=IE(\lambda_2)/IE(\lambda_1)= K1(\lambda_1)/K2(\lambda_2) \cdot V1/V2 \, [N_2^+ (B)]/[H(n'=2)]$$

Les intensités lumineuses relatives à chaque émetteur peuvent donc être considérées comme proportionnelles au même volume émetteur, ainsi :

$$FNS/H_\alpha=K1(\lambda_1)/K2(\lambda_2) \cdot [N_2^+ (B)]/[H(n'=2)]$$

Les demandeurs ont constaté que le rapport inverse $H_\alpha$/FNS (1/X) peut être défini aisément et peut être considéré pour la présente invention.

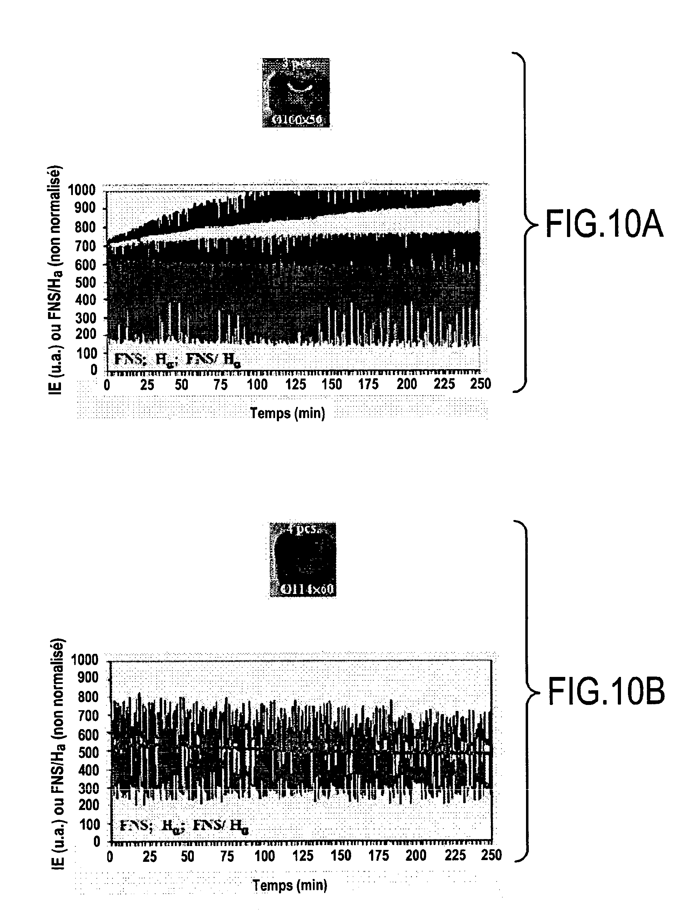

La stabilité sur une longue échelle de temps du rapport FNS/$H_\alpha$ est démontrée par les résultats présenté dans les Figures 10a et 10b. La Figure 10a montre le suivi des intensités FNS, $H_\alpha$ et du rapport FNS/$H_{.\alpha}$ pendant un cycle de nitruration d'une série de substrats de grandes dimensions (3 unités de dimensions $\phi160\times56$ mm) mais sans l'utilisation du procédé de contrôle selon l'invention. La Figure 10a montre le caractère instable du rapport FNS/$H_\alpha$ pendant le cycle de fonctionnement. Ceci résulte des conditions de nitruration instables du substrat 106 même en fixant les paramètres externes du procédé (pression, composition du mélange, température du substrat). L'effet du procédé de contrôle est montré par la Figure 10b. Cette figure est un chronogramme des intensités FNS, $H_\alpha$ et du rapport FNS/$H_{.\alpha}$ durant la phase de nitruration d'un substrat comparable (4 unités de dimensions $\phi114\times60$ mm) en appliquant la méthode 300. Ces résultats montrent que le comportement du rapport FNS/$H_\alpha$ et les conditions de nitruration sont stables durant le fonctionnement.

A titre d'exemple, l'homme de l'Art peut considérer le rapport X FNS/ $H_\alpha$ tel que la vitesse de nitruration avec obtention d'une couche de diffusion totalement exempte de précipitation de types $Fe_4N$ ou $Fe_{2-3}N$. Ainsi, la valeur de 25% $N_2$ constitue une limite supérieure acceptable pour obtenir ces propriétés de façon générale. Cependant, pour une qualité d'acier donnée, une valeur plus faible peut être requise. Ainsi pour un acier de type DIN 1.2367 (EN X38CrMoV5-3), traité dans les conditions correspondant au cas de la Figure 10b (avec un photomultiplicateur Hamamatsu R 928, des filtres passe-bande à 391,4 nm, FWHM= 2nm et filtres passe-bande à 656,3 nm, FWHM = 2 nm), les conditions expérimentales sont une pression de 4,3 mbar, une température de 520°C et une valeur de 1 pour le rapport FNS/$H_\alpha$ qui renvoie à une composition du mélange gazeux régulée autour de 3% $N_2$/97%$H_2$. Cette valeur du rapport FNS/$H_\alpha$ renvoie aux conditions optimales pour garantir une couche de diffusion complètement exempte de phase précipitée de type $Fe_4N$ ou $Fe_{2-3}N$ et la vitesse de nitruration maximale, ici soit 18 microns (critère dureté supérieure à 800 HV) par heure.

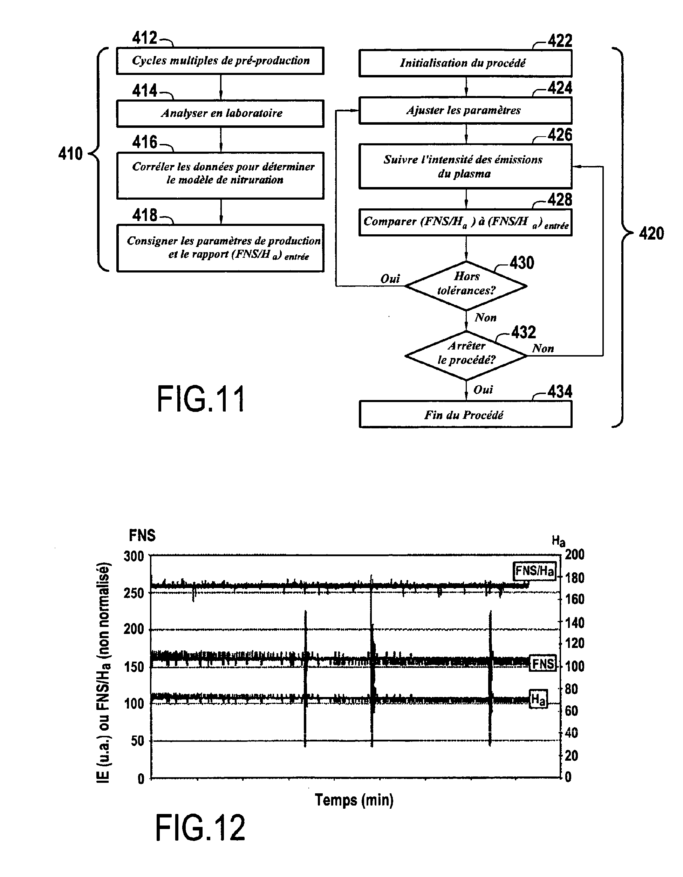

La figure 11 est un organigramme illustrant un algorithme 400 utilisé pour amorcer le procédé de nitruration assistée par plasma dans n'importe quel appareil pour un traitement duplex en continu en se basant sur le rapport FNS/$H_\alpha$ fixé après des séries d'essais en pré-production. Une séquence de pré-production 410 permet d'ajuster et de fixer la valeur du rapport FNS/$H_\alpha$ après de multiples cycles de pré-production 412, une étape d'analyse en laboratoire 414 des substrats 106 traités dans différentes conditions et l'établissement d'une corrélation 416 des propriétés des substrats traités avec les propriétés et structures requises de la couche nitrurée. La séquence de pré-production 410 conduit à la valeur du rapport FNS/$H_\alpha$ (paramètre X) comme consigne 418 afin de préparer une séquence définitive 420 comprenant une étape d'initialisation du procédé 422 moyennant l'ajustement de la composition du mélange gazeux (étape d'ajustement 424) et une étape de suivi des émissions optiques FNS et $H_\alpha$ 426. L'estimation instantanée de la valeur du rapport X et la comparaison 428 avec la valeur de consigne $X_r$ détermine l'étape suivante du procédé après évaluation. Si la valeur du paramètre $X_i$ est en dehors de l'intervalle de tolérance (évaluation 430) qui a été déterminée lors de la séquence de pré-production 410, la boucle peut ainsi être fermée en changeant la composition du mélange gazeux A (étape 424). Si la valeur du paramètre $X_i$ est en accord avec la valeur de référence $X_r$, seulement l'étape de suivi 426 est nécessaire et le procédé peut alors fonctionner jusqu'à l'ordre 422 d'arrêt 424. L'algorithme 400 assure l'obtention de couches nitrurées ayant exactement la même structure dans des réacteurs différents indépendamment des différences liées à leur construction et caractéristiques des systèmes de génération de puissance. Les demandeurs font remarquer que le rapport $FNS/H_\alpha$ (paramètre X) peut être remplacé par le rapport inverse $H_\alpha/FNS$ (paramètre 1/X) dans l'algorithme 400.

La Figure 12 montre le chronogramme des intensités FNS ($D_1$) et $H_\alpha$ ($D_2$) ainsi que le signal de contrôle $FNS/H_\alpha$ ($X = D_1/D_2$) enregistré durant un cycle de nitruration exécuté dans un appareil STANDARD 1 selon la valeur du rapport $FNS/H_\alpha$ fixée antérieurement lors de séries de pré-production effectuées dans l'appareil MZ-383. Ces résultats montrent que le comportement du rapport $FNS/H_\alpha$ et les conditions de nitruration sont stables durant le fonctionnement.

**Revendications**

1. Procédé de contrôle d'un processus de nitruration assistée par plasma, d'un substrat en acier placé dans une enceinte, ledit procédé comprenant une étape d'introduction dans ladite enceinte d'un mélange gazeux A comprenant de l'azote, et une étape de formation dans ladite enceinte d'un plasma de décharge comprenant des espèces réactives vis à vis de la nitruration dudit substrat en acier, ledit procédé étant **caractérisé en ce qu'**il comprend en outre les étapes suivantes :

   a. mesurer par spectroscopie optique d'émission (SOE) les émissions optiques provenant de deux espèces réactives et émettrices E1 et E2, E1 étant $N_2^+$ et E2 étant H, présentes dans le plasma de décharge dans le voisinage du substrat, pour obtenir des valeurs $D1_i$ et $D2_i$ correspondant aux signaux analogiques liés aux émissions des espèces E1 (FNS) et E2 (n'=1,2,3→n=2,3,4,5,6,7,8) respectivement;
   b. traiter les données $D1_i$ et $D2_i$ en vu d'obtenir un paramètre $X_i$ et de comparer celui-ci à une valeur de référence $X_r$;
   c. ajuster, le cas échéant, le débit d'au moins un des constituants gazeux et/ou la pression du mélange A afin de maintenir le paramètre X proche de la valeur $X_r$ pendant toute la durée de la nitruration.

2. Procédé selon la revendication 1 dans lequel le paramètre $X_i$ est défini par le rapport des données $D1_i$ et $D2_i$ ($X_i = D1_i/D2_i$ ou $Xi = D2_i/D1_i$).

3. Procédé selon l'une quelconque des revendications précédentes, dans lequel la comparaison entre une valeur du paramètre $X_i$ et celle du paramètre de référence $X_r$ se fait par une technique de reconnaissance des formes.

4. Système pour la mise en oeuvre du procédé de contrôle selon l'une des revendications 1 à 3, ledit système comprenant :

   i. une enceinte réactionnelle (102) comportant un support cathodique (108) et des moyens d'obtention d'un plasma de décharge à partir d'un mélange gazeux A comprenant de l'azote introduit dans ladite enceinte (102) ; l'enceinte (102) présentant une fenêtre (200) permettant le passage du rayonnement émis par le plasma ;
   ii. des moyens de transmission optique aptes à diriger le rayonnement émis pas le plasma à travers la fenêtre (200) vers des moyens collecteurs de rayonnement;
   iii. une unité centrale (216) recevant les données transmises par lesdits moyens collecteurs de rayonnement (202) ;
   iv. des moyens de contrôle et de transmission (220) d'une commande émanant de l'unité centrale (216) vers un dispositif de contrôle et régulation (224) des paramètres du mélange gazeux A.

5. Système selon la revendication 4, dans lequel les moyens collecteurs de rayonnement consistent en un spectrographe (202) équipé d'un ou plusieurs détecteurs.

6. Système selon la revendication 5, dans lequel les moyens collecteurs de rayonnement consistent en un dispositif de filtres équipés de photomultiplicateurs (210).

7. Système selon l'une quelconque des revendications 4 à 6, dans lequel les moyens de transmission optique comprenant un câble à fibre optique (208) et un jeu de lentilles (212).

8. Système selon l'une quelconque des revendications 4 à 7, dans lequel ladite unité centrale (216) comprend une carte d'acquisition de données (214), une unité de stockage de données (218) et un processeur (222).

9. Système selon l'une des revendications 4 à 8 dans lequel le dispositif de contrôle et régulation (224) des paramètres du mélange gazeux A comprend une unité de contrôle (314), une unité de consigne de la pression (310), une jauge active (312), un premier régulateur de débit massique (316) qui pilote une première valve (318), un second régulateur de débit massique (320) qui pilote une seconde valve (322).

FIG.1

FIG.2

FIG.3

FIG.4

FIG.5A

FIG.5B

**300**

**210**     **302**     **304**        **220**        **306**

| F-PMT 1 (FNS) | → | | | |
| F-PMT 1 ($H_a$) | → | A/D | → | FNS/$H_a$ |

Contrôleur PID

Consigne FNS/$H_a$

**222**

Consigne Pression   →   Jauge active   →   Unité de Contrôle    **314**

**310**     **312**

Régulateur Débit 1    **316**

Régulateur Débit 2    **320**

**318**    Valve 1      Valve 2    **322**

# FIG.6

FIG.7

FIG.8

FIG.9

FIG.10A

FIG.10B

412 — Cycles multiples de pré-production

414 — Analyser en laboratoire

416 — Corréler les données pour déterminer le modèle de nitruration

418 — Consigner les paramètres de production et le rapport (FNS/H $_a$) $_{entrée}$

410

422 — Initialisation du procédé

424 — Ajuster les paramètres

426 — Suivre l'intensité des émissions du plasma

428 — Comparer (FNS/H $_a$) à (FNS/H $_a$) $_{entrée}$

430 — Hors tolérances?  Oui  Non

432 — Arrêter le procédé?  Non  Oui

434 — Fin du Procédé

420

## FIG.11

FNS ... H $_a$

IE (u.a.) ou FNS/H $_a$ (non normalisé)

Temps (min)

## FIG.12

Office européen
des brevets

**RAPPORT DE RECHERCHE EUROPEENNE**

Numéro de la demande

EP 06 37 0018

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WALKOWICZ J ET AL: "THE INFLUENCE OF THE N2-H2 MIXTURE COMPOSITION ON THE SPECTROSCOPIC AND TEMPORAL BEHAVIOUR OF GLOW DISCHARGE CHARACTERISTICS IN PULSE-SUPPLIED NITRIDING PROCESSES" SURFACE AND COATINGS TECHNOLOGY, ELSEVIER, AMSTERDAM, NL, vol. 180/181, 2004, pages 407-412, XP008058849 ISSN: 0257-8972 * page 407 - page 412 * ----- | 1-9 | INV. H01J37/32 G01N21/71 |
| X | CLEUGH D: "PLASMA SPECIES ANALYSIS FOR IN SITU ASSESSMENT OF SURFACE TREATMENTS" SURFACE ENGINEERING, INSTITUT OF MATERIALS, LONDON, GB, vol. 18, no. 2, 2002, pages 133-139, XP008058874 * page 133 - page 139 * ----- | 1-9 | |
| X,D | FR 2 698 377 A (MARZINOTTO ANDRE; HELD BERNARD) 27 mai 1994 (1994-05-27) | 4-9 | DOMAINES TECHNIQUES RECHERCHES (IPC) |
| A | * page 3, ligne 19 - page 4, ligne 10; figures 1-4 * ----- | 1 | C23C H01J G01N |
| X | US 6 627 463 B1 (SARFATY MOSHE) 30 septembre 2003 (2003-09-30) | 4-9 | |
| A | * abrégé; revendications 1-4,7,8; figures 1-9 * ----- | 1 | |

Le présent rapport a été établi pour toutes les revendications

| Lieu de la recherche | Date d'achèvement de la recherche | Examinateur |
|---|---|---|
| La Haye | 22 août 2006 | Elsen, D |

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 06 37 0018

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

22-08-2006

| Document brevet cité au rapport de recherche | | Date de publication | Membre(s) de la famille de brevet(s) | Date de publication |
|---|---|---|---|---|
| FR 2698377 | A | 27-05-1994 | AUCUN | |
| US 6627463 | B1 | 30-09-2003 | AUCUN | |

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2698377